# EUROPÄISCHE PATENTSCHRIFT

(11) **EP 0 418 408 B1**
(45) Veröffentlichungstag und Bekanntmachung des Hinweises auf die Patenterteilung: **01.06.1994**
(21) Anmeldenummer: 89117326.2
(22) Anmeldetag: 19.09.1989
(51) Int. Cl.: H03K 17/691, H03K 17/723

(54) **Verfahren und Schaltungsanordnung zum Ansteuern eines Halbleiterschalters unter Verwendung eines induktiven Übertragers**
Method and circuit arrangement for controlling a semiconductor switch by using an inductive transformer
Procédé et montage pour la commande d'un commutateur semi-conducteur avec utilisation d'un transformateur inductif

(43) Veröffentlichungstag der Anmeldung: 27.03.1991
(73) Patentinhaber: SIEMENS AKTIENGESELLSCHAFT, 80333 München (DE)
(72) Erfinder: Blöckl, Reinhard, Dipl.-Ing., D-8025 Unterhaching (DE)

(56) Entgegenhaltungen:
- EP-A- 0 154 062
- DE-A- 2 827 736
- US-A- 4 758 941

## Beschreibung

Die Erfindung betrifft Verfahren zum Ansteuern eines Halbleiterschalters unter Verwendung eines induktiven Übertragers nach dem Oberbegriff des Patentanspruches 1 sowie Schaltungsanordnungen zur Durchführung solcher Verfahren.

Solche Verfahren und Schaltungsanordnungen sind prinzipiell bekannt. Sie werden je nach Ausführungsform des induktiven Übertragers zum potentialfreien Ansteuern von Halbleiterschaltern eingesetzt, aber auch um den Ansteuerstrom oder die Ansteuerspannung zu erhöhen. Solche Verfahren bzw. Schaltungsanordnungen können unter anderem bei Schaltnetzteilen, insbesondere Resonanzwandlerschaltnetzteil en eingesetzt werden.

Bei solchen bekannten gattungsgemäßen Verfahren wird meistens der Halbleiterschalter durch ein puls-dauer-moduliertes Signal eventuell mit variabler Frequenz und variablem Tastverhältnis, angesteuert. Die Gleichkomponente solcher Ansteuersignale führt ohne entsprechende Gegenmaßnahmen dazu, daß der Übertrager magnetisch gesättigt wird, sodaß eine gezielte Ansteuerung des Halbleiterschalters nicht möglich ist.

Unter anderem aus dem Artikel "Zuverlässiger Betrieb von MOSFETs in Brückenschaltungen" von H.R. Hässig und P. Zeller, Elektronik, Heft 10, 1989, Seite 55 bis 63, insbesondere Bild 1b auf Seite 56 ist ein Verfahren zur Ansteuerung eines Halbleiterschalters bekannt, wobei ein Ansteuersignal kapazitiv an den induktiven Übertrager eingekoppelt wird. Die hierbei verwendete Kapazität hält die Gleichkomponente von der Primärseite des Übertragers ab. Diese Kapazität wird auf einen dem Mittelwert des Ansteuersignales entsprechendes Gleichpotential aufgeladen und gibt diesem Gleichpotential überlagerte Wechselsignale an den Übertrager ab. Die Spannungsamplituden der Wechselsignale sind also von der Höhe des Gleichpotentiales abhängig. Durch eine Änderung des Tastverhältnisses des Ansteuersignales ändert sich bei solchen Anordnungen die Gleichkomponente an der Kapazität und somit auch die Amplitude der Ansteuerspannung am Halbleiterschalter.

Ein anderes gattungsgemäßes Verfahren ist unter anderem aus der "Technische Mitteilung aus dem Bereich Bauelemente", Integrierte Schaltnetzteil-Steuerschaltungen mit TDA 4700/TDA 4718, Funktion und Anwendung" der Fa. Siemens, München, 1980, insbesondere Bild 19 auf Seite 29 bekannt. Bei diesem Verfahren wird ein induktiver Übertrager mit einer zusätzlichen Entmagnetisierungswicklung verwendet, wobei diese zusätzliche Entmagnetisierungswicklung insbesondere über eine Diode an ein festes Potential geschaltet ist. Über diese Entmagnetisierungswicklung wird bei einer entsprechenden, von der Ansteuerung beeinflußten Änderung des Schaltzustandes des Halbleiterschalters die bei der Impulsübertragung in den Übertrager eingebrachte Feldenergie abgebaut. Da diese Entmagnetisierungswicklung gemeinsam mit parasitären Schaltungskapazitäten wie z.B. der Eingangskapazität des Halbleiterschalters einen Resonanzkreis bildet, wird die Feldenergie üblicherweise periodisch abgebaut. Um ein hierdurch bedingtes, ungewolltes Schalten des Halbleiterschalters zu verhindern, muß der Sekundärkreis des induktiven Übertragers entsprechend bedämpft werden. Eine solche Bedämpfung des Sekundärkreises des Übertragers führt zu Leistungsverlusten und muß außerdem in Abhängigkeit von der bei Entmagnetisierungsvorgängen wirksamen Induktivität und von der Entmagnetisierungsvorgängen wirksamen Kapazität dimensioniert werden.

Aufgabe der Erfindung ist das Bereitstellen eines Verfahrens zum Ansteuern eines Halbleiterschalters unter Verwendung eines induktiven Übertragers, bei dem die Amplitude der Ansteuerspannung nicht vom Tastverhältnis des Ansteuersignales abhängt und bei dem ein ungewünschtes Schalten des Halbleiterschalters aufgrund einer periodisch ablaufenden Entmagnetisierung des Übertragers verhindert wird sowie das Bereitstellen einer Schaltungsanordnung zur Durchführung eines solchen Verfahrens.

Diese Aufgabe wird erfindungsgemäß gelöst durch ein gattungsgemäßes Verfahren mit den Merkmalen des kennzeichnenden Teiles des Patentanspruches 1 bzw. durch eine Schaltungsanordnung nach dem Patentanspruch 4.

Günstige Ausgestaltungsformen sind Gegenstand von abhängigen Ansprüchen.

Wesentlich für ein erfindungsgemäßes Verfahren ist es, daß nach dem Abschluß der Entmagnetisierung des induktiven Übertragers die Spannung auf der Primärseite des Übertragers so klein gehalten wird, daß auf der Sekundärseite des Übertragers keine Spannung entstehen kann, die zu einem Schalten des Halbleiterschalters führen kann. Das kann dadurch erreicht werden, daß die beiden Anschlußklemmen auf der Primärseite des Übertragers auf das gleiche Potential geschaltet werden oder dadurch, daß die Primärwicklung des Übertrages kurzgeschlossen wird. Schaltungstechnisch bedingte Potentialdifferenzen zwischen den beiden Anschlußklemmen der Primärseite des Übertragers, die beispielsweise durch pn-Übergänge in der primärseitigen Schaltung des Übertragers entstehen können, stören hierbei nicht, solange ein vom Typ des Halbleiterschalters und vom Übersetzungsverhältnis des Übertragers abhängiges Potential auf der Sekundärseite nicht überschritten wird.

Ein mögliches Kriterium für den Abschluß der Entmagnetisierung ist, daß der Strom in der Primärwicklung des Übertragers im Nulldurchgang ist bzw. einen Vorzeichenwechsel erfährt. Ein anderes mögliches Kriterium für den Abschluß der Entmagnetisierung ist, daß die Spannung an der Primärwicklung des Übertragers einen bestimmten Wert erreicht. Beide Kriterien können in dem Fachmann bekannter Weise durch Komparatorschaltungen erfaßt werden.

Die Entmagnetisierung des induktiven Übertragers kann in bekannter Weise durch entsprechend geschaltete Freilaufdioden erfolgen, die nach Abschalten des Magnetisierungspotentiales den Übertrager an ein Entmagnetisierungspotential schalten. Anstatt der Freilaufdioden können jedoch auch elektronische Schalter verwendet werden.

Für den Fall, daß durch das Anliegen eines Schaltpotentiales an der Primärseite des Übertragers der anzusteuernde Halbleiterschalter schaltet - beispielsweise schließt - kann nach dem Abschalten des Schaltpotentiales ein weiteres Schalten - bsp. Öffnen - des Halbleiterschalters dadurch beschleunigt werden, daß für einen Zeitraum (maximal bis zum Ende der Entmagnetisierung) ein Entmagnetisierungspotential mit der der Polarität des Schaltpotentiales entgegengesetzten Polarität an die Primärwicklung des Übertragers angeschaltet wird.

Nachstehend werden anhand der Figuren Schaltungsanordnungen zur Durchgeführung eines erfindungsgemäßen Verfahrens beschrieben.

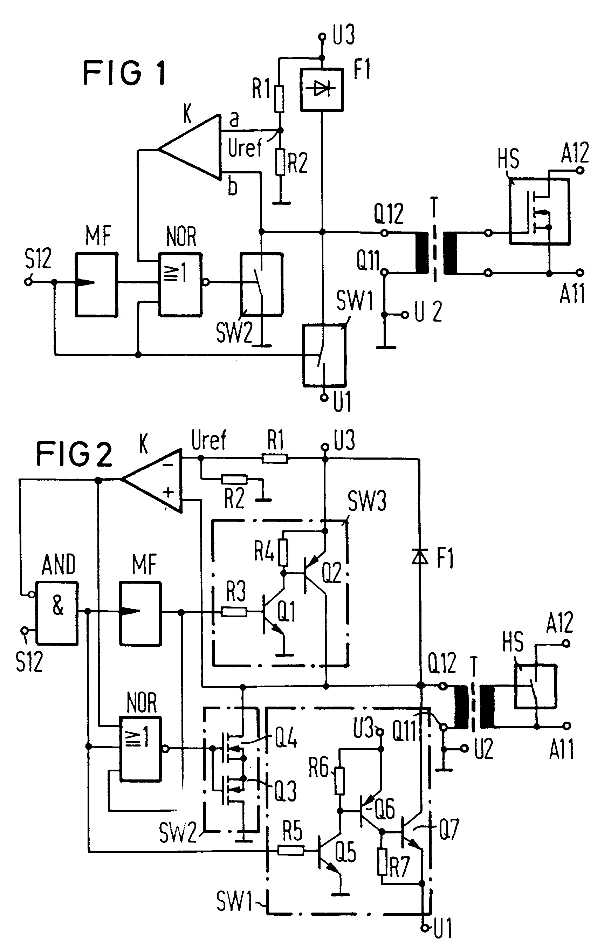

Es zeigt
- Figur 1: eine erfindungsgemäße Schaltungsanordnung zur Durchführung erfindungsgemäßer Verfahren für den Fall, daß eine Anschlußklemme Q11 der Primärwicklung des Übertrager T an ein Bezugspotential U2 geschaltet ist und die andere Anschlußklemme Q12 des Übertragers T von einer Ansteuerschaltung angesteuert wird, wobei die Ansteuerschaltung mit Versorgungspotentialen U1 und U3 versorgt ist und U1>U2>U3 oder U3>U2>U1 gilt.
- Figur 2: eine Schaltung nach Figur 1 für den Fall U3>U2>U1 mit möglichen Ausführungsformen der Schalter in der Ansteuerschaltung, mit einem weiteren, die Entmagnetisierung beschleunigenden Schalter SW3 und mit einer zusätzlichen logischen Funktion AND, die die magnetische Sättigung des Übertragers T verhindert.

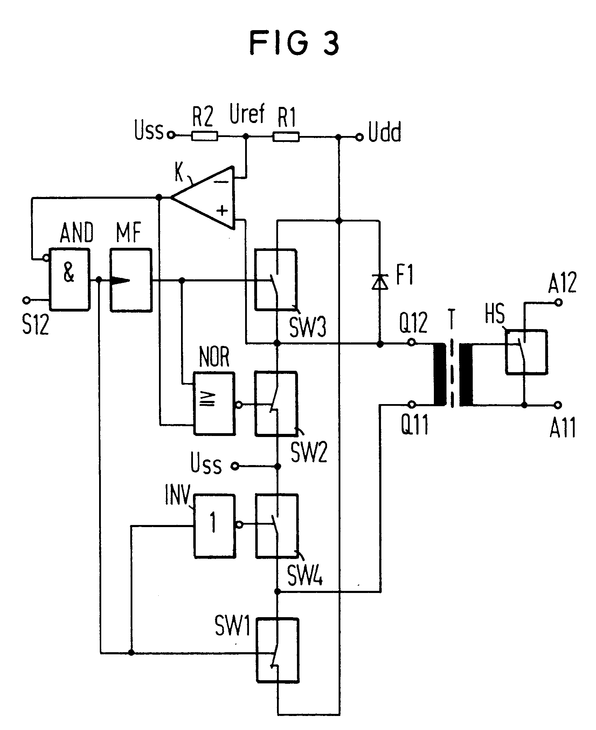

- Figur 3: eine erfindungsgemäße Schaltungsanordnung zur Durchführung erfindungsgemäßer Verfahren für den Fall,
daß außer der Bezugsspannung Uss nur eine Versorgungsspannung Udd erforderlich ist, daß beide Anschlußklemmen Q11 und Q12 der Primärwicklung des Übertragers T von einer Ansteuerschaltung angesteuert werden und für den Spezialfall, daß Schalter SW3 und SW4 zur Beschleunigung der Entmagnetisierung des Übertragers T vorgesehen sind und daß durch eine logische Funktion AND die magnetische Sättigung des Übertragers T verhindert wird.

Figur 1 zeigt eine Schaltungsanordnung zur Durchführung erfindungsgemäßer Verfahren mit einem Steuereingang S12, der mit dem Steuereingang eines ersten Schalters SW1, mit dem Eingang eines auf die fallende Flanke getriggerten monostabilen Flip-Flops MF und mit einem Eingang eines NOR-Gatters NOR verbunden ist. Der Ausgang des Monoflops MF ist mit einem weiteren Eingang dieses NOR-Gatters NOR verbunden und ein dritter Eingang dieses NOR-Gatters NOR ist mit dem Ausgang eines Komparators K zusammengeschaltet. Der Ausgang des NOR-Gatters NOR ist mit dem Steuereingang eines zweiten Schalters SW2 zusammengeschaltet. Die erste Klemme Q11 der Primärwicklung des induktiven Übertragers T ist an ein Bezugspotential U2 geschaltet. Die zweite Klemme Q12 der Primärwicklung des induktiven Übertragers T ist über den ersten Schalter SW1 an ein erstes Versorgungspotential U1 schaltbar, über den zweiten Schalter SW2 an das Bezugspotential U2 schaltbar, über ein Freilaufelement F1, bsp. eine Freilaufdiode an ein zweites Versorgungspotential U3 geschaltet und mit einem Eingang b des Komparators K verbunden. Der andere Eingang a des Komparators K ist mit einem Referenzpotential Uref beaufschlagt, das im Ausführungsbeispiel nach Figur 1 dadurch eingestellt wird, daß der Eingang a über einen ersten Widerstand R1 an das zweite Versorgungspotential U3 und über einen zweiten Widerstand R2 an das Bezugspotential U2 geschaltet ist. Für den Fall U3 > U2 > U1 ist der Eingang a der invertierende Eingang und der Eingang b der nichtinvertierende Eingang des Komparators K und eine Freilaufdiode F1 ist mit ihrer Anode an die Klemme Q12 der Primärwicklung des Übertragers T angeschlossen. Eine Klemme der Sekundärwicklung des Übertragers T ist mit dem Steuereingang eines Halbleiterschalters HS verbunden, der die Strecke zwischen den Ausgangklemmen A11 und A12 öffnen oder schließen kann, die andere Klemme der Sekundärwicklung des Übertragers T ist mit der Ausgangsklemme A11 verbunden.

Die Polarität der einzelnen Schaltungsteile wie die des Freilaufelementes F1 und die der Eingänge a und b des Komparators ist von der Polarität der Versorgungspotentiale U1 und U3, von der Art des anzusteuernden Halbleiterschalters HS, vom Wickelsinn der einzelnen Wicklungen des Übertragers T und von der Funktionsweise des Halbleiterschalters (Öffner oder Schließer) in einer dem Fachmann bekannten Weise abhängig.

Im folgenden wird die Funktionsweise eines Ausführungsbeispiels nach Figur 1 beschrieben. Wenn ein Einschaltsignal am Eingang S12 anliegt, ist der erste Schalter SW1 eingeschaltet und über die NOR-Funktion ist der zweite Schalter SW2 ausgeschaltet. Die Primärwicklung des Übertragers T wird dadurch zwischen die beiden Potentiale U1 und U2 geschaltet und nimmt magnetische Energie auf. Mit dem Feldaufbau im tibertrager T ist ein Magnetisierungsstrom in Richtung der Potentialdifferenz verbunden. Gleichzeitig wird eine dem Windungszahlenverhältnis entsprechende Sekundärspannung als Steuerspannung an den Halbleiterschalter HS angelegt, der dadurch eingeschaltet wird. Solange am Steuereingang S12 ein Einschaltsignal anliegt, bleibt der Schaltzustand des Halbleiterschalters HS unverändert.

Wird das Einschaltsignal am Eingang S12 abgeschaltet und geht somit über in ein Ausschaltsignal, so schaltet das auf die fallende Flanke getriggerte Monoflop MF einen Impuls kostanter Dauer an den Eingang des NOR-Gatters NOR. Dadurch bleibt der zweite Schalter SW2 weiterhin, auch ohne Einschaltsignal am Steuereingang S12 für die Dauer der Monoflop-Zeitkonstanten gesperrt. Der erste Schalter SW1 sperrt nach Wegfall des Einschaltsignales an seinem Steuereingang ebenfalls.

Wenn nach Wegfall des Einschaltsignales am Eingang S12 sowohl der erste Schalter SW1 als auch der zweite Schalter SW2 gesperrt sind, wirkt der Übertrager T aufgrund seiner Selbstinduktion als Stromquelle und liefert einen Strom, der in Richtung und Größe mit dem Magnetisierungsstrom übereinstimmt. Nach dem Umladen der am Übertrager vorhandenen Kapazitäten, bsp. der Eingangskapazität des Halbleiterschalters HS, fließt der Strom durch das Freilaufelement F1, das dazu für die entsprechende Stromrichtung leitend sein muß. In diesem Moment liegt am Steuereingang des Halbleiterschalters HS eine Ansteuerspannung umgekehrter Polarität vor, sodaß HS sicher sperrt.

Durch den Umladevorgang im Übertrager ändert sich die Spannung an der Klemme Q12 und somit am Eingang b des Komparators K. Wenn die Spannung am Klemme Q12 die Referenzspannung Uref erreicht, legt der Komparator K eine Spannung an einen Eingang des NOR-Gatter NOR und verhindert somit, daß der zweite Schalter SW2 schließen kann. Die Zeitkonstante des Monoflops MF muß so gewählt werden, daß das Ausgangssignal des Monoflops MF das NOR-Gatter NOR nach Wegfall des Ansteuersignales am Steuereingang S12 so lange sperrt, bis in Folge des Umladevorganges im Übertrager T der Komparator K das NOR-Gatter NOR sperrt. Die magnetische Feldenergie des Übertragers T kann bei geöffneten Schaltern SW1 und SW2 über das Freilaufelement F1 abgebaut werden. Der Entmagnetisierungsstrom nimmt dabei ab, wird zu Null und wechselt dann das Vorzeichen, sodaß das Freilaufelement F1 sperrt. Im Nulldurchgang des Entmagnetisierungsstromes ist der Übertrager in energiefreiem Zustand. Das Potential an Klemme Q12 der Primärwicklung des Übertragers T entspricht nahezu dem über das Freilaufelement F1 angeschalteten Versorgungspotential U3 und ändert sich dann in Richtung des anderen Versorgungspotentiales U1. Wenn das Potential an Klemme Q12 und somit am Eingang b des Komparators K das an Klemme a des Komparators K anliegender Referenzpotential Uref erreicht, ändert der Komparator K sein Ausgangssignal und gibt somit einen Eingang des NOR-Gatters NOR frei. Das Referenzpotential Uref wird vorteilhafterweise so gewählt, daß der Komparator K den Eingang des NOR-Gatters freigibt, wenn der Übertrager T weitgehend energiefrei ist, also im Bereich des Nulldurchganges des Entmagnetisierungsstromes. Die Zeitkonstante des Monoflops MF sollte so gewählt werden, daß der Ausgang des Monoflops bereits vor diesem Zeitpunkt den zweiten Eingang des NOR-Gatters NOR freigegeben hat. Wenn dann kein erneutes Einschaltsignal am Steuereingang S12 anliegt ist auch der dritte Eingang des NOR-Gatters NOR freigegeben, sodaß das Ausgangssignal des NOR-Gatters NOR den zweiten Schalter SW2 leitend schaltet.

Ist der zweite Schalter SW2 leitend, so ist die Primärwicklung des Übertrager T kurzgeschlossen. Der Übertrager T ist also im energiefreien oder zumindest nahezu energiefreien Zustand und außerdem beträgt die Primär- und somit auch die Sekundärspannung am Übertrager 0 Volt oder nahezu 0 Volt. Der zweite Schalter SW2 sollte möglichst bidirektional leitend sein, damit evtl. Restströme fließen können. Ein ungewolltes Schalten des Halbleiterschalters HS kann in diesem Schaltzustand sicher verhindert werden, wenn ein evtl. Reststrom im Übertrager an den Leitungs- und Bauteilimpedanzen keine Spannung erzeugen kann, die zu einem Schalten des Halbleiterschalters HS führt. Das kann durch geeignete Wahl des Halbleiterschalters HS so wie durch geeignete Wahl des Übertragers T und der Ansteuerschaltungselemente in dem Fachmann bekannter Weise sichergestellt werden.

Das Ausführungsbeispiel in Figur 2 unterscheidet sich von dem in Figur 1 unter anderem dadurch, daß der Ausgang des Monoflops MF zusätzlich zum Ansteuern eines dritten Schalters SW3 vorgesehen ist, dessen schaltbare Strecke parallel zur Freilaufdiode F1 angeordnet ist und durch den der Entmagnetisierungsvorgang beschleunigt wird. Hierzu ist der Ausgang des Monoflops MF sowohl an einen Eingang des NOR-Gatters NOR geschaltet als auch an den Steuereingang des dritten Schalters SW3. Die steuerbare Strecke des dritten Schalters SW3 ist zwischen die Klemme Q12 der Primärwicklung des Übertragers T und das zweite Versorgungspotential U3 geschaltet. Als dritter Schalter SW3 kann hierbei jeder Schalter mit geeigneter Durchlaßrichtung verwendet werden. Als besonderes Ausführungsbeispiel eines integrierbaren dritten Schalters SW3 ist in Figur 2 eine Anordnung aus zwei Widerständen R3 und R4 und einem npn-Transistor Q1 als Eingangstransistor sowie einem pnp-Transistor Q2 als Schalttransistor gezeigt. Der Basisanschluß des Transistors Q1 ist hierbei über einen der Strombegrenzung dienenden Widerstand R3 an den Steuereingang des Schalters SW3 geschaltet. Der Emitteranschuß des Transistors Q1 ist an Bezugspotential geschaltet und sein Kollektoranschluß ist mit dem Basisanschluß des Transistors Q2 verbunden und über einen Widerstand R4 an das zweite Versorgungspotential U3 geschaltet. Der Emitteranschluß des Transistors Q2 bildet einen Eingang der steuerbaren Strecke des Schalters SW3 und ist an das Versorgungspotential U3 geschaltet. Der Kollektoranschluß des Transistors Q2 bildet den anderen Eingang der steuerbaren Strecke des Schalters SW3 und ist mit der Klemme Q12 des Übertragers T4 verbunden. Wenn das Eingangssignal des auf die fallende Flanke getriggerten Monoflops MF von high auf low fällt, wird für die Zeit der Monoflop-Zeitkonstanten, also länger als bis zum Einschalten des Komparators K und nicht solange als bis zum Wiederausschalten des Komparators K die Klemme Q12 parallel zum Freilaufelement F1 über den dritten Schalter SW3 an das zweite Versorgungspotential U3 geschaltet, so daß die Entmagnetisierung des Übertragers T beschleunigt abläuft. Solche Schaltungsvarianten sind besonders bei Anwendungen mit relativ großer kapazitiver Last im Sekundärkreis des Übertragers empfehlenswert, also beispielsweise bei Halbleiterschaltern mit großer Eingangskapazität.

Außerdem unterscheidet sich eine Schaltungsanordnung nach Figur 2 von einer nach Figur 1 dadurch, daß bei einer Schaltungsanordnung nach Figur 2 erst dann ein weiterer Einschaltimpuls vom Steuereingang S12 an den ersten Schalter SW1 weitergeleitet werden kann, wenn die Entmagnetisierung des Übertragers T abgeschlossen ist. Zu diesem Zweck ist der Schaltungsknoten, der in Figur 1 mit dem Steuereingang S12 verbunden ist mit dem Ausgang eines AND-Gatters AND zusammengeschaltet. Ein Eingang dieses AND-Gatters AND bildet den Steuereingang S12, der andere Eingang des AND-Gatters AND wird mit dem invertierten Ausgangssignal des Komparators K beaufschlagt. Deshalb ist in Figur 2 das AND-Gatter AND mit einem invertierenden Eingang dargestellt, der mit dem Ausgang des Komparators K zusammengeschaltet ist. Durch diese Schaltungsvariante kann die magnetische Sättigung des Übertragers infolge von Einschaltimpulsen mit zu hoher Folgefrequenz verhindert werden.

Als zweiter Schalter SW2 ist in Figur 2 das Ausführungsbeispiel eines bidirektional leitfähigen Halbleiterschalters, bestehend aus zwei Feldeffekttransistoren Q3 und Q4 gezeigt. Der Steuereingang des Schalters SW2 ist hierbei jeweils mit dem Gate-Anschluß beider Transistoren Q3 und Q4 zusammengeschaltet, die Source-Anschlüsse der beiden Transistoren Q3 und Q4 sind miteinander verbunden und die Drain-Anschlüsse der beiden Transistoren Q3 und Q4 bilden jeweils einen Eingang der steuerbaren Strecke des Schalters SW2. Zum sicheren Ein- bzw. Ausschalten des Schalters SW2 sollte der Ausgang des NOR-Gatters NOR einen hinreichend großen Spannungshub ausführen können, beispielsweise zwischen U1 (gesperrt) und U3 (leitend). Gegebenenfalls kann zwischen den Ausgang des NOR-Gatters NOR und den Steuereingang des zweiten Schalters SW2 eine geeignete Treiberschaltung zwischengeschaltet werden.

Das Ausführungsbeispiel des ersten Schalters SW1 in Figur 2 besteht aus einer Schaltung, wie sie den dritten Schalter SW3 bildet, wobei R3, R4, Q1 und Q2 des Schalters SW3 den Bauelementen R5, R6, Q5 und Q6 im ersten Schalter SW1 entsprechen, doch ist der Kollektoranschluß des pnp-Transistors Q6 mit dem Basisanschluß eines weiteren npn-Transistors Q7 und über einen weiteren Widerstand R7 mit dem Emitteranschluß dieses Transistors Q7 und dem ersten Versorgungspotential U1 verbunden, während der Kollektoranschluß des Transistors Q7 an die Klemme Q12 des Übertragers T angeschlossen ist. Dadurch ist gewährleistet, daß der erste und der dritte Schalter SW1 und SW3 durch das gleiche Ansteuerpotential schaltbar sind, obwohl sie die Klemme Q12 an Versorgungspotentiale unterschiedlicher Polarität schalten.

Figur 3 zeigt als Ausführungsbeispiel eine Schaltungsanordnung zur Durchführung erfindungsgemäßer Verfahren mit einem Steuereingang S12, der mit einem Eingang eines AND-Gatters AND verbunden ist. Der andere Eingang dieses AND-Gatters AND ist invertierend ausgeführt und mit dem Ausgang eines Komparators K sowie mit einem Ausgang eines NOR-Gatters NOR verbunden. Der Ausgang des AND-Gatters AND ist mit dem Eingang eines auf die fallende Flanke getriggerten monostabilen Flipflops MF, mit dem Eingang eines Invertierers INV und mit dem Steuereingang eines ersten Schalters SW1 verbunden. Der Ausgang des Monoflops MF ist an den Steuereingang eines dritten Schalters SW3 und an einen weiteren Eingang des besagten NOR-Gatters NOR angeschlossen. Der Ausgang dieses mit zwei Eingängen ausgestatteten NOR-Gatters NOR ist mit dem Steuereingang eines zweiten Schalters SW2 verbunden, der Ausgang des Invertierers INV ist mit dem Steuereingang eines vierten Schalters SW4 zusammengeschlossen.

Eine Anschlußklemme Q11 der Primärwicklung eines Übertragers T ist über die steuerbare Strecke des ersten Schalters SW1 an ein Versorgungspotential Udd schaltbar und über die steuerbare Strecke des vierten Schalters SW4 an das Bezugspotential Uss schaltbar. Durch den Invertierer INV wird sichergestellt, daß immer einer dieser beiden Schalter geöffnet und einer geschlossen ist. Die andere Anschlußklemme Q12 der Primärwicklung des Übertragers T ist mit dem nichtinvertierenden Eingang des Komparators K verbunden, über eine Freilaufdiode F1 an das Versorgungspotential Udd geschaltet, über die steuerbare Strecke des zweiten Schalters SW2 an das Bezugspotential Uss schaltbar und über die steuerbare Strecke des dritten Schalters SW3 an das Versorgungspotential Udd schaltbar. Durch das NOR-Gatter NOR ist hierbei sichergestellt, daß nur entweder der Schalter SW2 oder der Schalter SW3 geschlossen sein kann.

Der nichtinvertierende Eingang des Komparators K ist mit einem Referenzpotential Uref beaufschlagt, das im Ausführungsbeispiel dadurch eingestellt ist, daß der nichtinvertierende Eingang des Komparators K über einen ersten Widerstand R1 an das Versorgungspotential Udd und über einen zweiten Widerstand R2 an das Bezugspotential Uss geschaltet ist. Die Sekundärseite des Übertragers T dient in bekannter Weise zur Ansteuerung eines Halbleiterschalter HS, der die Strecke zwischen den Anschlußklemmen A11 und A12 schalten kann.

Wenn der Ausgang des Komparators K auf Low-Pegel liegt und am Steuereingang S12 kein Einschaltsignal anliegt ist über das AND-Gatter AND der erste Schalter SW1 geöffnet und über den Invertierer INV der vierte Schalter SW4 geschlossen. Außerdem ist über das Monoflop MF der dritte Schalter SW3 geöffnet und über das NOR-Gatter NOR der zweite Schalter SW2 geschlossen. Das AND-Gatter AND ist an seinem invertierenden Eingang über den Ausgang des Komparators K freigegeben.

Wird an den Steuereingang S12 ein Einschaltsignal angelegt, so wird über das AND-Gatter AND der erste Schalter SW1 geschlossen und gleichzeitig über die Invertiererschaltung INV der vierte Schalter SW4 geöffnet. Dieser Schaltzustand ist in Figur 3 dargestellt. Die Klemme Q11 der Primärwicklung des Übertrager T ist dann über den Schalter SW1 an das Versorgungspotential Udd geschaltet und die Klemme Q12 der Primärwicklung des Übertragers T ist über den Schalter SW2 an das Bezugspotential Uss geschaltet. Der Übertrager T nimmt dabei magnetische Energie auf und der Halbleiterschalter wird auf der Sekundärseite des Übertragers T eingeschaltet und bleibt solange in diesem Zustand, wie am Steuereingang S12 ein Einschaltsignal anliegt.

Bei einem Wechsel des Ansteuersignales am Steuereingang S12 von High- auf Low-Pegel wird über das AND-Gatter AND der erste Schalter SW1 geöffnet und über den Invertierer der vierte Schalter SW4 geschlossen. Gleichzeitig wird durch die fallende Flanke am Ausgang des AND-Gatters AND das Monoflop MF getriggert und dessen Ausgangssignal sorgt für die Zeitdauer der Monoflopzeitkonstanten dafür, daß der dritte Schalter SW3 geschlossen wird. Aißerdem wird ein eingang des NOR-Gatters NOR blockiert, so daß der Schalter SW2 geöffnet wird. Die Polarität der an den Klemmen Q11 und Q12 der Primärwicklung des Übertragers T anliegenden Spannung wird dadurch geändert, der Halbleiterschalter HS wird ausgeschaltet und der Entmagnetisierungsvorgang des Übertragers T ist eingeleitet. Die Zeitkonstante des Monoflops MF und die Schaltschwelle und somit die Schaltzeitpunkte des Komparators K sollten, wie bei Schaltungen nach Figur 1 bzw. Figur 2 beschrieben, aufeinander abgestimmt sein, so daß infolge des Entmagnetisierungsvorganges das Potential an Klemme Q12 über das Referenzpotential Uref ansteigt und somit der Komparator K durch ein High-Signal an dem einen Eingang das NOR-Gatter NOR (und an einem Eingang das AND-Gatter AND) sperrt, bevor das Ausgangssignal des Monoflops MF sich ändert und den dritten Schalter SW3 öffnet sowie an dem anderen Eingang das NOR-Gatter nicht mehr sperrt. Ist der dritte Schalter geöffnet, so läuft die Entmagnetisierung über die Freilaufdiode F1 weiter, wobei der Entmagnetisierungsstrom linear abnimmt, zu Null wird und dann, wie oben beschrieben, sein Vorzeichen ändert. In diesem Zeitpunkt ist der Übertrager T entmagnetisiert. Das Potential an der Klemme Q12 des Übertragers ist nahezu gleich dem Versorgungspotential Udd und sinkt nun ab. Wenn das Potential an der Klemme Q12 das Referenzpotential Uref erreicht, schaltet der Komparator K ein Low-Signal an das NOR-Gatter NOR und an das AND-Gatter AND. Das Ausgangssignal des NOR-Gatters schließt den zweiten Schalter SW2, so daß die Primärwicklung des Übertragers T kurzgeschlossen ist. Außerdem ist das AND-Gatter AND freigegeben.

Durch die kurzgeschlossene Primärwicklung des Übertragers T ist, wie schon für Schaltungen nach Figur 1 und Figur 2 beschrieben, sicher verhindert, daß der Halbleiterschalter HS schalten kann. Ein weiteres Schalten des Halbleiterschalters HS wird somit solange verhindert, bis an den Steuereingang S12 ein neues Einschaltsignal angelegt wird.

Selbstverständlich kann ein erfindungsgemäßes Verfahren auch durch andere, als die in den in den Figuren 1, 2 und 3 gezeigten Ausführungsbeispielen verwendeten Logikschaltungen realisiert werden. Hierbei ist die Wahl der logischen Verknüpfungen unter anderem von der Wahl der einzelnen Schalter, vom Wickelsinn des Übertragers T und vom Typ des Übertragers abhängig. Diese Zusammenhänge sind dem Fachmann bekannt. Wenn eine Strommeßwicklung oder eine andere Einrichtung zur Erfassung des Stromes des Übertragers vorgesehen ist, kann der Komparator auch als Stromnulldurchgangsdetektor ausgeführt sein.

## Patentansprüche

1. Verfahren zum Ansteuern eines Halbleiterschalters (HS) unter Verwendung eines induktiven Übertragers (T) mit Primärseite und Sekundärseite, wobei der anzusteuernde Halbleiterschalter (HS) auf der Sekundärseite des Übertragers (T) angeordnet ist, wobei ein an der Primärseite des Übertragers (T) angelegtes Schaltpotential einer bestimmten Polarität zum Schalten des Halbleiterschalters (HS) führt, wobei im Übertrager (T) eventuell gespeicherte magnetische Energie mit Hilfe einer Schaltungsanordnung zur Entmagnetisierung des Übertragers (T) aus dem Übertrager (T) abgeführt wird bevor auf der Primärseite des Übertragers (T) - einen Schaltvorgang am Halbleiterschalter (HS) bewirkende - elektrische Energie zugeführt wird,
**dadurch gekennzeichnet,** daß nach der Entmagnetisierung des Übertragers (T) ein Anwachsen des Potentials auf der Primärseite des Übertragers (T) über einen zulässigen Wert dadurch verhindert wird, daß die Klemmen der Primärseite des Übertragers (T) auf das gleiche Potential geschaltet werden.

2. Verfahren nach Anspruch 1,
**dadurch gekennzeichnet,** daß nach dem Abschalten des Schaltpotentials - maximal bis zum Ende der Entmagnetisierung - über einen steuerbaren Schalter (SW3) ein Entmagnetisierungspotential mit der der Polarität des Schaltpotentiales entgegengesetzten Polarität an die Primärseite des Übertragers (T) angeschaltet wird.

3. Verfahren nach Anspruch 2,
**dadurch gekennzeichnet,** daß dieses Entmagnetisierungspotential nicht während der gesamten Entmagnetisierungsphase über den steuerbaren Schalter (SW3) angeschaltet wird.

4. Schaltungsanordnung zum Ansteuern eines Halbleiterschalters (HS) mit einem induktiven Übertrager, mit einem Steuereingang (S12), mit einer Logikschaltung (MF, NOR) mit mindestens einem steuerbaren Schalter (SW1; SW1, SW2), der eine Spannung (U1-U2; Udd-Uss) an die Primärwicklung des Übertragers (T) schalten kann und mit mindestens einem Freilaufelement (F1), das eine Spannung entgegengesetzter Polarität (U2-U3; Uss-Udd) an die Primärwicklung des Übertragers (T) schalten kann,
**gekennzeichnet durch** Schaltmittel (K) zum Erfassen der Beendigung der Entmagnetisierung des Übertragers (T) und durch weitere Schaltmittel (SW2; SW2, SW4) zum Kurzschließen der Primärwicklung des Übertragers (T), wobei die weiteren Schaltmittel (SW2; SW2, SW4) ansprechen, nachdem die Schaltmittel (K) die Beendigung der Entmagnetisierung des Übertragers (T) detektiert haben.

5. Schaltungsanordnung nach Anspruch 4,
**dadurch gekennzeichnet,** daß dem Freilaufelement (F1) ein steuerbarer Schalter (SW3) parallelgeschaltet werden kann.

6. Schaltungsanordnung nach Anspruch 4 oder 5,
**dadurch gekennzeichnet,** daß die weiteren Schaltmittel (SW2; Sw2, SW4) zum Kurzschließen der Primärwicklung des Übertragers (T) bidirektional leitend sind.

## Claims

1. Method of driving a semiconductor switch (HS) using an inductive transformer (T) having a primary side and a secondary side, the semiconductor switch (HS) to be driven being arranged on the secondary side of the transformer (T), a switching potential of a certain polarity applied on the primary side of the transformer (T) causing switching of the semiconductor switch (HS), any stored magnetic energy there may be in the transformer (T) being dissipated from the transformer (T) with the aid of a circuit arrangement for demagnetizing the transformer (T) before electrical energy - effecting a switching operation at the semiconductor switch (HS) - is supplied on the primary side of the transformer (T), characterized in that, after the demagnetization of the transformer (T), an increase in the potential on the primary side of the transformer (T) beyond a permissible value is prevented by the terminals of the primary side of the transformer (T) being connected to the same potential.

2. Method according to Claim 1, characterized in that, after switching off the switching potential - at the latest by the end of the demagnetization - a demagnetizing potential of opposite polarity to the polarity of the switching potential is switched via a controllable switch (SW3) to the primary side of the transformer (T).

3. Method according to Claim 2, characterized in that this demagnetizing potential is not switched via the controllable switch (SW3) during the entire demagnetization phase.

4. Circuit arrangement for driving a semiconductor switch (HS) having an inductive transformer, having a control input (S12), having a logic circuit (MF, NOR) with at least one controllable switch (SW1; SW1, SW2), which can switch a voltage (U1-U2; Udd-Uss) to the primary winding of the transformer (T), and having at least one freewheeling element (F1), which can switch a voltage of opposite polarity (U2-U3; Uss-Udd) to the primary winding of the transformer (T), characterized by switching means (K) for sensing the ending of the demagnetization of the transformer (T) and by further switching means (SW2; SW2, SW4) for short-circuiting the primary winding of the transformer (T), the further switching means (SW2; SW2, SW4) responding after the switching means (K) have detected the ending of the demagnetization of the transformer (T).

5. Circuit arrangement according to Claim 4, characterized in that a controllable switch (SW3) can be connected in parallel with the freewheeling element (F1).

6. Circuit arrangement according to Claim 4 or 5, characterized in that the further switching means (SW2; SW2, SW4) for short-circuiting the primary winding of the transformer (T) are bidirectionally conducting.

## Revendications

1. Procédé pour commander un commutateur à semiconducteurs (HS), en utilisant un transformateur inductif (T) ayant un côté primaire et un côté secondaire, qui consiste à monter le commutateur à semiconducteurs (HS) à commander sur le côté secondaire du transformateur (T), un potentiel de commutation appliqué au côté primaire du transformateur (T) et d'une polarité déterminée provoquant la commutation du commutateur à semiconducteurs (HS), de l'énergie magnétique éventuellement stockée dans le transformateur (T) en étant évacuée à l'aide d'un montage destiné à désaimanter le transformateur (T) avant que de l' énergie électrique - produisant une opération de commutation dans le commutateur à semiconducteurs (HS) - soit envoyée au côté primaire du transformateur (T), caractérisé par le fait qu'après la désaimantation du transformateur (T), on empêche le potentiel du côté primaire du transformateur (T) d'augmenter au-delà d'une valeur admissible en mettant les bornes du côté primaire du transformateur (T) au même potentiel.

2. Procédé suivant la revendication 1, caractérisé par le fait qu'après la suppression du potentiel de commutation - au maximum jusqu'à la fin de la désaimantation - on applique au côté primaire de transformateur (T) un potentiel de désaimantation de polarité opposée à celle du potentiel de commutation, par l'intermédiaire d'un interrupteur commandable (SW3).

3. Procédé suivant la revendication 2, caractérisé par le fait qu'on applique pas ce potentiel de désaimantation par l'intermédiaire de l'interrupteur commandable (SW3) pendant toute la phase de désaimantation.

4. Montage pour la commande d'un commutateur à semiconducteurs (HS) ayant un transformateur inductif, une entrée de commande (S12), un circuit logique (MF, NOR) comportant au moins un interrupteur commandable (SW1; SW1, SW2), qui peut appliquer une tension (U1-U2; Udd-Uss) à l'enroulement primaire du transformateur (T), et au moins un élément à effet unidirectionnel (F1), qui peut appliquer une tension de polarité opposée (U2-U3; Uss-Udd) à l'enroulement primaire du transformateur (T), caractérisé par des moyens de commutation (K) destinée à détecter la fin de la désaimantation du transformateur (T), et par d'autres moyens de commutation (SW2; SW2, SW4) destinés à court-circuiter l'enroulement primaire du transformateur (T), les autres moyens de commutation (SW2; SW2, SW4) étant excités après que les moyens de commutation (K) ont détecté la fin de la désaimantation du transformateur (T).

5. Montage suivant la revendication 4, caractérisé par le fait qu'un interrupteur commandable (SW3) peut être branché en parallèle avec l'élément à effet unidirectionnel (F1).

6. Montage suivant la revendication 4 ou 5, caractérisé par le fait que les autres moyens de commutation (SW2; SW2, SW4) sont conducteurs de façon bidirectionnelle pour court-circuiter l'enroulement primaire du transformateur (T).
